# EUROPEAN PATENT APPLICATION

(11) **EP 4 354 160 A1**
(43) Date of publication of application: **17.04.2024**
(21) Application number: 22275134.9
(22) Date of filing: 13.10.2022
(51) Int. Cl.: G01R 31/00, H01M 10/052, H01M 10/42, H01M 10/48, H01M 50/569

(54) **IMPROVEMENTS IN A CELL ASSEMBLY SAFETY AND AN ASSOCIATED SYSTEM**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

According to an aspect of the present invention there is provided a cell assembly comprising: a cell; a cell enclosure configured to substantially surround the cell; and an optical sensor deployed within the cell in a location where a chemical environment is active to monitor at least one of temperature, strain and an acoustic signature, the optical sensor configured in use to receive a pulse of light and output a signal which is detectable with an optical monitor.

## Description

### FIELD

The present invention relates to improvements in a cell assembly safety and an associated system, including, but not limited to the monitoring of Lithium-ion cells.

### BACKGROUND

The design and development of energy storage management systems for safety critical applications is a challenging area. Accurate monitoring of new Lithium-ion cell technologies is critical to the safe and prolonged operation of battery packs. Monitoring the health of Lithium-ion cells to determine state of charge (SoC) and state of health (SoH) is vital in establishing the condition of the cells though their entire lifecycle and is key to mitigating the catastrophic event of a thermal run-away condition.

Monitoring temperature, voltage, current and impedance are traditional methods used to determine cell health and to ensure correct charge and discharge conditions are maintained. Temperatures are typically measured across a group of cells. These traditional cell monitoring solutions can result in accuracy issues when determining cell health and aging, along with cell anomalies going undetected sometimes resulting in catastrophic thermal runaway events.

There is a need for improvements in cell enclosure such as but not limited to a pouch battery design and battery monitoring which overcome at least some of the abovementioned problems.

### SUMMARY

According to an aspect of the present invention there is provided a cell assembly comprising: a cell; a cell enclosure configured to substantially surround the cell; and an optical sensor deployed within the cell in a location where a chemical environment is active to monitor at least one of temperature, strain and an acoustic signature, the optical sensor configured in use to receive a pulse of light and output a signal which is detectable with an optical monitor.

In an aspect, the optical monitor comprising one or more Bragg gratings.

In an aspect, the output signal received from the optical monitor undergoes a frequency response analysis to determine any anomalous temperature data, strain data or acoustic signature.

In an aspect, the output signal provides information from charging and discharging of the cell which enable identification of the state of charge or health of the cell.

In an aspect, the output signal identifies anode cracking based on a specific acoustic response.

In an aspect, the output signal detects electrolyte evaporation prior to a thermal runaway event.

In an aspect, the output signal identifies a specific acoustic signature for a rupture of the cell.

In an aspect, the output signal gives rise to remedial action depending on the nature of an acoustic signature.

In an aspect, the output signal is compared to a predetermined safety value and wherein an alarm is produced if the output signifies a risk situation.

In an aspect, the optical sensor is located in a cavity in the cell.

In an aspect, the optical sensor that is embedded in the cell follows a folded path through the cavity in the cell.

In an aspect, the folded path takes a zigzag, z-shaped or snaked path through the cavity in the cell to enhance retention.

In an aspect, the optical sensor is located closer to one electrical terminal of the cell than another.

In an aspect, the optical sensor is configured to measure changes in reflection of the light pulse through the optical sensor based on the changes in any one of stain, temperature or acoustic signature based on changes on internal walls of the cell.

In an aspect, further comprising a printed sensor for monitoring at least one of strain and temperature.

According to an aspect of the present invention there is provided a cell assembly safety system for use with the cell assembly of any one of the preceding claims, comprising: an analysis module for each of one or more sensors configured to receive data from a respective one of one or more sensors; a control module for controlling the cell assembly safety system and generating alerts where the safety level indicates a risk.

In an aspect, the one or more analysis modules receive input from one or more of: a printed sensor; an acoustic sensor; and an optical sensor.

According to an aspect of the present invention there is provided a method of monitoring a cell assembly to determine a safety value of the cell, the method comprising sensing, via an optical sensor, one or more acoustic signatures representing respective electrochemical reactions in the cell (101) to determine a state of health or state of charge of the cell or generate a safety value.

In an aspect, further comprising: sensing a combination of the following signatures: a continuous acoustic signature; a pulse type acoustic signature; an acoustic signature related to acoustic emissions from electrolyte evaporation; and a gas formation acoustic signature of cell venting.

In an aspect, the combination includes the acoustic signature and the gas formation acoustic signature.

In an aspect, the combination includes: the continuous acoustic signature; the pulse type acoustic signature; the acoustic signature; and the gas formation acoustic signature.

In an aspect, further comprising a printed sensor for sensing strain and temperatures, the method further comprising sensing at least of one of strain and temperature via the printed sensor and to update the state of health or state of charge of the cell or generate the safety value

In an aspect, further comprising comparing changes in expansion of the cell to a predetermined safety value and producing an alarm if the expansion is greater than or equal to the predetermined safety value.

In an aspect, further comprising comparing the one or more acoustic signatures with normal acoustic features to determine an anomaly therebetween.

In an aspect, the acoustic signatures generated from the cell is analysed to provide at least one of a representation of the electrochemical reaction occurring during the lifecycle of the cell.

### BRIEF DESCRIPTION OF THE FIGURES

Embodiments of the invention will now be described by way of example only with reference to the figures, in which:
Figure 1 shows a cell assembly, according to one aspect of the current application;
Figure 2 shows a view from above of the empty enclosure for the figure 1 cell assembly;
Figure 3 shows a cell for use in the cell assembly of Figure 1;
Figure 4 shows a block diagram of a battery safety system according to an aspect of the current application; and
Figure 5 shows a number of cell assemblies joined together.

### DETAILED DESCRIPTION

The current application relates to the use of strain data from novel low cost sensors printed directly onto a cell such as for example a pouch cell. The strain data is combined with traditional voltage, current and impedance data to enhance the accuracy of cell monitoring. Pack deformation data provides further critical information to support the use of cells within safety critical applications. The cell may be of any type including but not limited to a Lithium-ion cell.

The invention further relates to the use of strain sensors for pack deformation monitoring and the use of printed sensors which are directly printed onto cells for ease of manufacture. In addition, the use of printed sensors with embedded temperature sensing, to monitor cell case deformation and temperature through charge and discharge cycles are described.

Lithium-ion pouch cells typically increase and reduce in thickness during charge and discharge cycles, this phenomenon is commonly referred to as "cell breathing". During cell aging this "breathing" can reduce over time with cell expansion increasing gradually, providing a key indicator on the age and health of the cell. The cell can also expand rapidly due to a thermal run-away condition, therefore being able to monitor sudden cell swelling can provide an early warning of a potential thermal run-away event.

Cell safety can be particularly critical in different environments requiring different intrinsic levels of safety. Some environments may require only minor safety requirements being met, others may need to deal with major, hazardous or catastrophic potential safety requirements. For example airborne requirements would require substantially more demanding safety requirements than automotive. Being able to provide higher levels of safety can be costly and difficult to implement. The current application seeks to provide a high level of safety using relatively inexpensive monitoring circuitry which can be used in conjunction with other monitoring circuitry to increase still further the level of safety and sensor redundancy. This will be described in greater detail below.

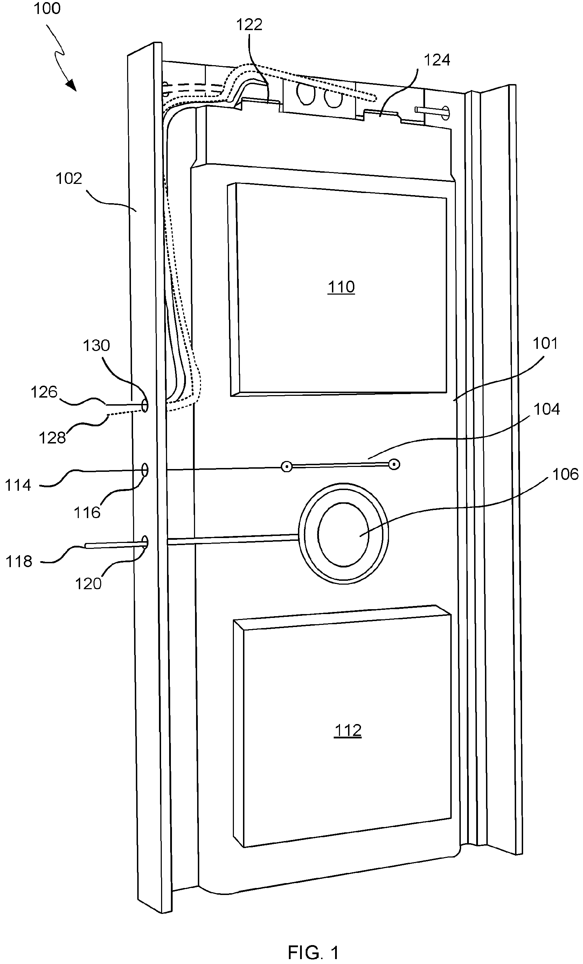

Figure 1 shows a cell assembly 100 comprising a cell 101 (a pouch cell in the example shown) held within a cell enclosure shown generally as 102. The cell enclosure can be manufactured from a lightweight composite material which provides a flame retardant and thermal barrier. The cell is a Lithium-ion cell as an example. The cell includes a printed strain and/or temperature sensor 104 (for brevity the printed sensor 104 herein) and an acoustic sensor 106 attached to the face of the cell. Thermal pads 110 and 112 are shown on either side of the sensors, although a single pad covering the entire cell face and sensors would be the preferred solution depending on the sensor impact with the compression pad. The thermal pads 110 and 112 attach to cell 101 and provide thermal heat transfer from the cell. It will be noted that the cell 101 could be any other type of cell including other types of cell enclosure.

The printed sensor 104 is of the appropriate size and shape to detect micro strains from the surface of the cell. The printed sensor 104 is printed directly onto the cell. Typically cells have an aluminium polymer foil outer layer and the printed sensor 104, can be directly printed onto a laminate with a PSA backing and then manually applied to the cell in an alternative example. This allows the printed sensor 104 to be located in different positions including wrapping the printed sensor 104 around the edge of the cell to maximise Z plane sensing. The printed sensor 104 shape will be adjusted to maximise gauge factor to detect micro-strains appropriate for the size of the cell. The printed sensor 104 can be protected with a coating to avoid damage from abrasion with the compression pad or other adjacent material.

The printed sensor 104 is designed to maximise temperature monitoring accuracy whilst not impacting the printed sensor 104 sensitivity or accuracy. A method to decouple strain from temperature is deployed using, for example. impedance and phase shift monitoring, allowing the printed sensor 104 to simultaneously monitor both strain and temperature. The contacts from the printed sensor 104 are in the form of rigid tails by encapsulation within a polymer material in an example.

The printed sensor 104 includes a long thin sensor in the form of a nano-ink sensor in one example (as shown in Figure 1). The printed sensor 104 in the example shown includes two wires but can be different shapes including any 2D shape and can be positioned at different locations. Only one printed sensor 104 is shown but there may be more in some situations. There is an output wire 114 from the printed sensor 104 which passes through an enclosure side hole 116. The printed sensor 104 monitors micro-strains and temperature to determine deformation of the cell as the cell "breathes" and generates an alarm if the cell approaches a thermal runaway condition. Deformation of the cell or temperature changes will result in both an impedance and/or phase shift which can be monitored and converted to micro strain and temperature and are used to indicate a SoH/SoC of the cell and runaway thermal conditions.

The first time the cell is charged it typically expands with regards to thickness, combined with surface expansion within the X and Y axes. The cell then discharges as it is used and typically reduces in thickness. The difference between the maximum and minimum size is referred to herein as a delta. The delta is an indication of the state of health and the state of charge of the cell. Over time the delta decreases and the cells can become permanently larger depending on cell technology, this is a useful indication of the age of the cell with regard to cycle life. Even near end-of-life there is still a delta between the fully charged state and the discharged state which is continually monitored. If the cells becomes suddenly swollen then this is indicative of an anomaly in cell operation. Any cell deformation not associated with charge and discharge cycles are monitored with an associated alert being generated. The battery management system can switch off a number of cells associated with the swollen cell to help mitigate against a thermal run-away event.

The cells can include just one sensor for monitoring a safety value or metric but may also include more. Further such sensors will now be described.

The analysis of the cell may further include a comparison with known acoustic signatures, measured by the acoustic sensor 106,occurring in a normal lifecycle of the cell (normal acoustic signatures). If the comparison identifies anomalies above or below predetermined thresholds, an alert is generated, via an alert generation system, and remedial action is taken. Embedded sensors resilient to the harsh chemical reactions occurring within the cell are used in some examples. These are mounted in any appropriate location inside or outside the enclosure.

The acoustic sensor 106 can determine a number of different types of acoustic emissions, each providing different information about the state of the cell. The types of emission and associated signatures include a continuous acoustic emission and signature; a pulse type acoustic emission and signature; a signature related to acoustic emissions from electrolyte evaporation and subsequent gas formation and acoustic emissions and signatures of cell venting where a cell has ruptured and is venting gases.

The acoustic sensor 106 is a piezo acoustic sensor also including an output wire 118 which passes through a respective hole 120. The piezo-electric sensor 106 which determines the acoustic signature of the electrochemical reaction within the cell. The acoustic signatures generated from Lithium-ion cells is analysed to provide a representation of the electrochemical reaction occurring with time during the lifecycle of the cell including the charge and discharge cycles. Analysis of this acoustic information provides information for determining both cell health and aging. This analysis in some respects comprises a comparison with known acoustic signatures occurring in a normal lifecycle of the cell (normal acoustic signatures). If the comparison identifies anomalies above or below predetermined thresholds, an alert is generated, via an alert generation system, and remedial action is taken.

The acoustic signature provides early warning of anode cracking along with cell aging information through degradation of the normal continuous emissions generated by the electrochemical reaction. These sensors provide support in advances of cell health monitoring for safety critical applications. Using the acoustic signature provides an early warning that a thermal run-away events is imminent and to enable mitigation to maximise the cell performance. The sensor or sensors are located on the battery or any framework associated therewith, including the cell enclosure.

The acoustic sensor determines that a cell vent has occurred with the emission of high pressure gases The acoustic sensor can determine a number of different types of acoustic emissions, each providing different information about the state of the cell, as described above. As an alternative to the acoustic piezo sensor an embedded optical sensor 300 may be used this is inserted in the cell and is described in greater detail below...

Data from the sensors is collected in respect of each type of emissions. The continuous acoustic emission provides aging information and the signature shows reductions in amplitude of the acoustic signal over time, these are referred to as first and second signatures. The pulse emissions capture cracking of the cell anode structure. A third signature related to acoustic emissions from electrolyte evaporation and subsequent gas formation is generated. This third signature provides an early warning for a thermal runaway condition. Cell expansion detection through the use of printed sensor 104, combined with acoustic emission monitoring for electrolyte evaporation and gas generation, would provide dissimilar/redundant monitoring schemes to enhance confidence of the event occurring. A fourth signature is based on the acoustic emissions of cell venting where a cell (whatever the type) has ruptured and is venting gases. This fourth signature identifies that a cell vent has occurred with the emission of high pressure gases including Volatile Organic Chemicals (VOCs) and thus subsequent action is urgently required to mitigate further cell assembly damage. Including acoustic monitoring with VOC/ CO₂ monitoring via a further independent sensor provides further dissimilar evidence of a cell rupture.

The third and fourth signatures in combination have the benefits of adding specialised safety monitoring which is particularly valuable in highly critical safety environments, such as for use in an aircraft. The use of different signatures adds to the benefits of acoustic sensors such as acoustic sensor 106 and optical sensor 300 (described below). There is a further benefit of greater redundancy and additional safety at minimal cost. The combination of signatures may include some or all of the different types of acoustic signatures.

A circuit design for the acoustic sensor or sensors includes the design of both filtering and amplification stages to enhance signature monitoring. It is noted that the acoustic sensor comprises one or more different sensors. The different sensors are configured to collect data from multiple cells simultaneously, if they are located on a battery pack chassis or the like and thereby reduces the costs associated with individual cell monitoring

The cell 101 further includes terminals 122 and 124 to which wires 126 and 128 are connected and pass through the enclosure via side holes 130. The connections to outside the cell assembly serve many different functions.

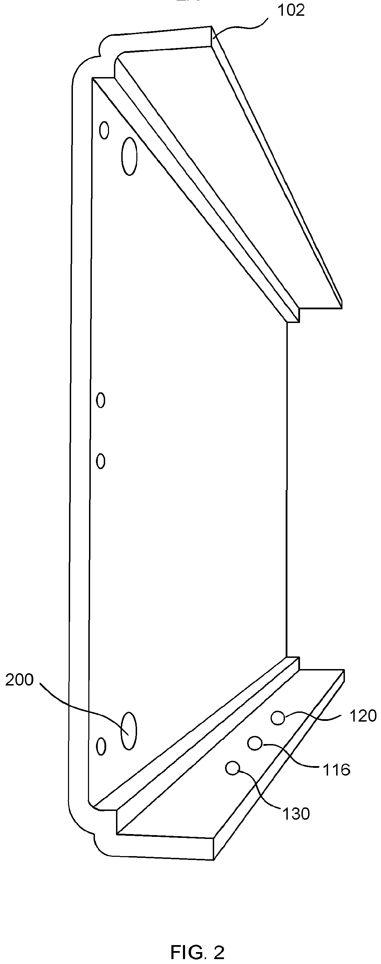

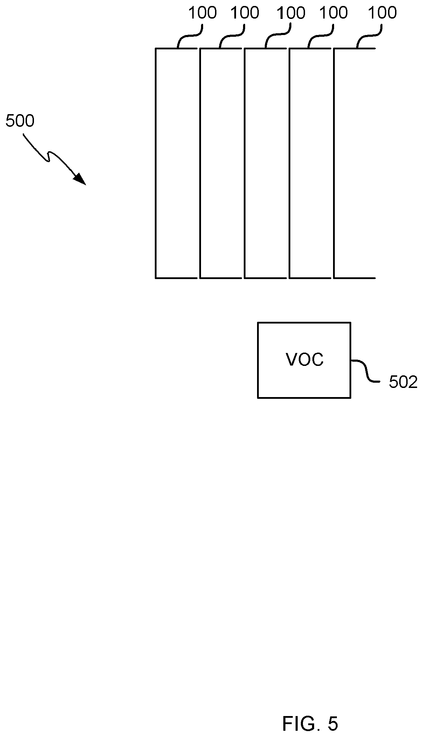

The cell enclosure 102 is generally rectangular and slightly larger than the size of the cell. The enclosure includes raised edges along the sides which are slightly less than the combined thickness of the cell and compression thermal pads. A top view of the cell enclosure can be seen in Figure 2. The cell enclosure acts as a partition plate between successive batteries. A stack of cells can be placed juxtaposed to one another with a cell enclosure or partition plate between them (this is described further in Figure 5). Rivet locations 200 show the locations where a small, printed circuit board (PCB) is attached to the composite cell enclosure . The PCB can contain electronic components to monitor the temperature above the cell and thus provide a dissimilar redundant temperature monitor. The circuit board could also provide the interface circuit for the printed sensor 104 and thus reducing the cabling requirements back to the main battery management system by utilising a transmission bus with multiple cells connected. The printed circuit board allows for the cell tabs to be welded to copper contact points on the board from which connection to a bus bar can be made. Alternatively cables can be run through the enclosures to adjacent cells for lower power solutions. Holes through the enclosure will be reduced to a minimum aperture to minimise heat transfer to adjacent cells.

A top and bottom plate are applied to the enclosure to enclose the cell, but is not shown. Also the top surface in some situations is another cell enclosure of another cell. The cell enclosure provides a lightweight and simple container for supporting and protecting the cell.

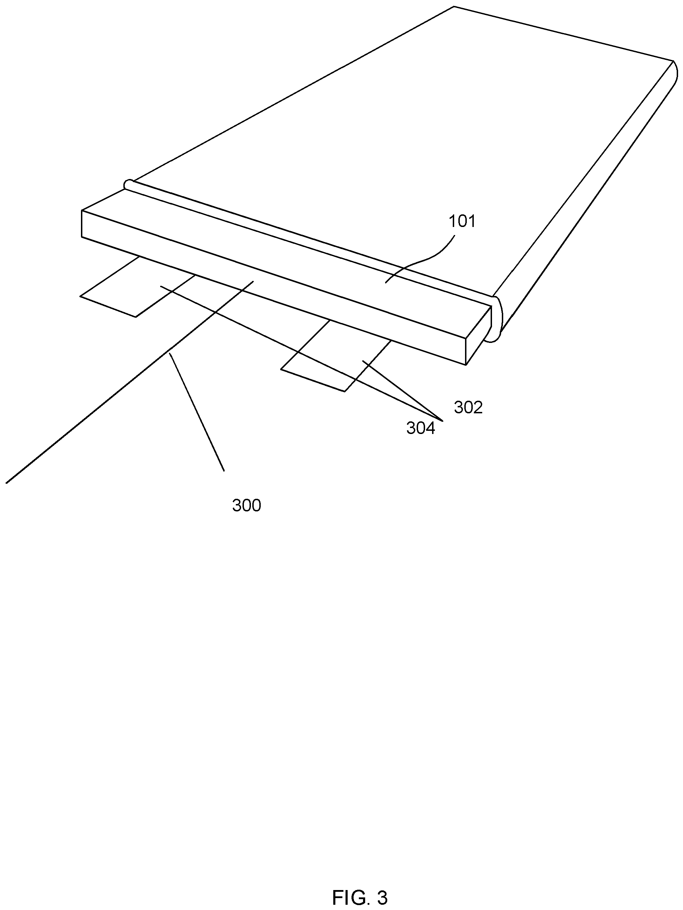

Figure 3 shows a Lithium-ion cell with two electrodes, anode 304 and cathode 302, extending therefrom.

The shapes and sizes of the cell and cell enclosure are not limited to being rectangular and could be any shape and/or size depending on use requirements or design, cell tabs could also exit from both ends of the cell.

The printed sensor 104 is a carbon nano-ink strain/temperature sensor which is applied directly to the cell. The carbon nano-ink strain/temperature sensor deforms as the cell changes and the deformation results in an impedance changes which are easy to process and compare with so called normal values which relate to a cell operating well. Traditional strain sensors are very difficult if not impossible to glue and attach to cell. The carbon nano-ink strain/temperature sensor has an advantage that it can be applied to the cell directly and comprises two wire. The carbon nano-ink strain/temperature sensor is adapted to measure both strain and temperature, the latter being of particular use in determining cell activity and age. Using a printed sensor 104, a cost effective assembly process can be scaled to accommodate packs containing thousands of cells or batteries. The invention provides the use of a printed sensor 104 monitoring on pouch and prismatic style cell packs in which both micro-strain and temperature sensing are combined. The use of printed sensors 104 means that each cell can be manufactured with a printed sensor 104 at reduced cost, compared to traditional foil cells. This further means that all cells in a pack can be monitored, not just a percentage. A further benefit is to reduce the complexities involved in mounting individual sensors across a cell assembly. Traditional foil gauges require time to adhere to the surface of the cell and are also thicker with solder connections which in some situations cause the cell to puncture.

As the cell breathes or expands (as mentioned above) the strain and/or temperature on the printed sensor 104 changes and data is collected at regular intervals to determine the changes. The data is collected for each cycle of discharge and charge and the delta between the two is monitored to give an indication of the state of health and state of charge of the cell. Monitoring the strain and/or temperature data provides information as to whether each cell is performing normally or not. The delta and associated temperature data from each sensor are collected, stored and compared with the initial delta and the health and charge are monitored based on the comparison. In addition, if the cell expands beyond a certain predetermined value this is often indicative of the cell approaching a thermal runaway. This determination gives rise to an alarm being raised and if necessary, the cell being switched off. The predetermined value is determined for a typical cell of the size and shape as the cell expansion may vary from cell to cell. Different cells have different expansion profiles. If the comparison suggests one or more cells are not responding in the normal manner or are outside the predetermined safety value the alert is raised via an alert generation system (not shown) and remedial action is taken as required.

The strain data and related temperature data from printed sensors 104 can be combined with traditional voltage, current and impedance data to enhance the accuracy of cell monitoring. This gives rise to pack deformation data which provides further critical information to support the use of Lithium-ion cells within safety critical applications.

The printed sensors 104 as previously mentioned provide the ability to monitor both micro-strain and temperature through the same sensor thus reducing the interface requirements per cell and the avoiding the need for a separate temperature sensor. The printed sensor 104 is typically manufactured from a carbon ink which is printed directly onto a cell face that is typically an aluminium polymer material for cells.

Cells may have alternate outer casing materials where the printed sensor 104 will be calibrated for that material.

Cell safety can be particularly critical in different environments requiring different intrinsic levels of safety. Some environments may require only minor safety requirements being met, others may need to deal with major, hazardous or catastrophic potential safety requirements. For example a cell assembly for use in an aircraft may have higher safety requirements than a cell assembly for use in a different place. Being able to provide higher levels of safety can be costly and difficult to implement. The current application seeks to provide a high level of safety using relatively inexpensive monitoring circuitry which can be used in conjunction with other monitoring circuitry to increase still further the level of safety. As will be described in greater detail below.

The acoustic sensor 106 is the piezo acoustic sensor also including an output wire 118 which passes through a respective hole 120. The piezo-electric sensor 106 which determines the acoustic signature of the electrochemical reaction within the cell. The acoustic signatures generated from Lithium-ion cells are analysed to provide a representation of the electrochemical reaction occurring during the lifecycle of the cell including the charge and discharge cycles. Analysis of this acoustic information provides information for determining both cell health and aging.

The acoustic signature provides early warning of anode cracking along with cell aging information through degradation of the normal continuous emissions generated by the electrochemical reaction. Embedded sensors resilient to the harsh chemical reactions occurring within the cell can also be used. These sensors provide support in advances of cell health monitoring for safety critical applications. Using the acoustic signature provides an early warning that a thermal run-away event is imminent and to enable mitigation to maximise the cell performance. The sensor or sensors are located on the cell or any framework associated therewith, including the enclosure. It should be noted that the optical sensor 300 described below can determine the same or similar acoustic signatures to the acoustic sensor 106.

As shown in Figure 3 an optical fibre sensor 300 (optical sensor 300) is deployed within the cell in a location where the chemical environment is active and will be formed as part of the normal cell manufacture process. The optical sensor 300 acts as an acoustic sensor for the chemical environment activity and is capable of determining gases being released into the environment which is potential indicator of thermal runaway or other risks. The optical sensor 300 replaces the acoustic sensor 106 in some examples and is able to determine at least the same acoustic signatures as the acoustic sensor 106. The output from the optical fibre sensor 300 is monitored and can be used to sense acoustic signals from within the cell. In some examples both temperature and strain can also be determined through a Bragg gratings (not shown). A "smart cell" where a single protruding fibre optic cable thereby provides detailed cell sensing is produced. This will now be described in greater detail.

The optical sensor 300 as used in the Lithium-ion cell considers the monitoring of the acoustic signal through the use of an embedded optical glass fibre of any appropriate type. The optical sensor 300 is able to provide acoustic monitoring and both temperature and strain monitoring through the use of one or more added Bragg gratings thus creating a smart cell where a single protruding fibre optic cable can provide detailed cell sensing.

The optical sensor 300 is placed between two electrical tabs. The tabs form electrical connections depending on the cell technology and are installed during an agnostic lamination process in the normal construction of the cell. Depending on the nature of the cell and the type of chemical reactions which are to provide the acoustic data relating to the reaction, the optical sensor 300 may be closer to one electrical connection than the other. In certain cells, anode cracking may be an important indicator of the malfunction of the cell. As a result, the optical sensor 300 is positioned to be closer to the anode than the cathode.

The cell is provided with a small cavity through which the optical sensor 300 is introduced and positioned. This cavity can act as an acoustic or resonant cavity to couple acoustic signals into the optical fibre sensor. A light sense or pulse of light is passed through the optical sensor 300 and an output signal is received by one or more Bragg gratings (not shown). The Bragg grating detects changes in reflection of light from the optical sensor 300 from the internal walls of the cell between which the optical sensor passes. The changes in reflection are brought about by changes in the strain on the internal cell walls. The signals received from the Bragg grating undergo a frequency response analysis to determine any anomalous responses. This may be based on known responses or any other method of comparing the received response with a response that would be expected for a normal cell at a given point of time in its life cycle. It is noted that the Bragg grating is replaceable with other types of optical monitoring.

The optical fibre sensor that is embedded in the cell and takes a zigzag, z-shaped snaked path or any other "folded" or random path through the cavity in the cell in examples. In other words, a section of the optical sensor may be contained within the cell and take a zigzag, z-shaped or snaked path through a laminated section of the cell before leaving the cell. This zigzag, z-shaped or snaked path can act as a labyrinth and means that if the optical fibre sensor is accidentally pulled or snagged it will not be pulled out of the cell and provides enhanced retention of the fibre within the cell. In addition, the optical fibre sensor includes a tight seal where it is embedded in the small cavity in the cell or a tight seal where it exits the cell. This further increases the difficulty of accidentally pulling the optical fibre sensor out of the cell.

Cell pack deformation will directly impact the optical fibre within the cell thus generating an analysable optical response, likewise thermal and acoustic responses can also be detected.

There are different responses to different anomalies or risks. Signals relating to everyday data from the charging and discharging of the cell identify the state of charge or health of the cell. Anode cracking through stress on the anode structure during swelling of the anode can generates a specific acoustic response.

Thermal runaway results in electrolyte evaporation following high internal temperatures which generates an acoustic profile indicating this anomaly. There is a specific signature which may give rise to a thermal runaway condition and requires the cell to be shut down immediately.

The state of health or charge of the cell is helpful in identifying the age of the cell and whether is working correctly or not. In addition, acoustic signals can give rise to early warnings at which point the cell can be kept operating and monitored more frequently. For more serious anomalies or risks the acoustic signature can be used to determine to disconnect the cell assembly or take other remedial action. Monitoring the cell in this way gives rise to the ability to switch from one cell to another in circumstances where volatile organic compounds are detected or other risks identified. Emissions from these types of gases require an immediate shutdown and for the power to be provided from another source. This takes place before the gases escape, based on the monitored data from the sensors as described above. By fusing the data between the different sensors if any monitor is operating inaccurately the other sensors provide redundancy and backup monitoring.

The acoustic optical sensing provided by optical sensor 300 can be used in multiple different technologies. For sealed cells the technology is introduced at the point of manufacture for other types of cell technology it is introduced after manufacture.

Analysis of acoustic information and the fusing of it with traditional cell sensing, can then provide valuable information for both cell health and aging. One sensor is configured to identify the safety value or other data associated with state of health, state of charge and the like. A second sensor generates similar data and the combination of reading from the different sensors is combined to give updated the safety value or other data associated with state of health, state of charge and the like.

The shapes and sizes of the cell and cell enclosure are not limited to being rectangular and could be any shape and/or size depending on use requirements or design.

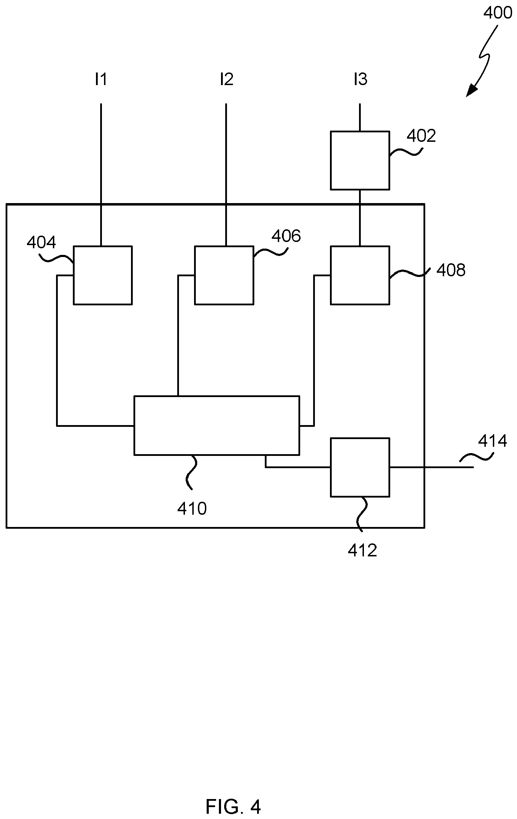

Referring to Figure 4 a cell assembly sensor system 400 is shown. The system includes three inputs I1, I2 and I3 from respective sensors 104, 106 and 300 in this example. Different numbers of input could be provided in different situations. On the input I3 a Bragg grating 402 is shown. Each input is connected to respective analysis modules 404, 406 and 408. The analysis modules are in communication with a control module 410.

The control module 410 sends instructions to the analysis modules 404, 406 and 408 and receives monitored data from each based on the sensor readings, thereby controlling the operations of the cell assembly safety system. The controller is configured to activate an alarm module 412 which provides an output 414. The output generates an alarm or instructs other activities, such as shutting down a cell which is operating poorly or dangerously. The control module can also directly shut down a cell without an alarm in systems where no separate alarm module is provided. The control module determines the safety value of the cell based on one or more of the inputs I1, 12 and 13. Where the cell is operating safely the control takes no further action other than a further check at regular intervals or where a dangerous reading is identified and alerted by the analysis module. In situations where not all inputs are required the control module controls just those analysis modules that are active.

Figure 5 shows a plurality of cell assemblies 100 which are attached or joined to one another is a stack 500. These may be joined together in any appropriate manner. In some cases this is a number of rods (not shown) passing through the four corners of each cell assembly. Associated therewith is a VOC monitor 502.

In situations where the safety level is less critical than others different numbers of monitors may be used. For example for a critical safety environment all three sensors described above may be used.

In the current application the printed sensor offers a less critical safety monitoring process for SoH and SoC. The acoustic monitoring and early warning of potential cracking which is a more serious safety issue. The optical sensor gives still further critical safety indicator in terms of determining potential thermal runaway which could result in rent or rupture of the cell. It will be appreciated that depending on the safety criticality of the environment different combinations of different sensors may be used. The more sensors used the greater the level of safety for a given situation. In addition, the sensors provide redundancy for one another in the event of failure of a sensor. All sensors provide the critical safety information, i.e. sudden cell expansion from the printed sensor, sudden acoustic response or high temperature.

The current application is described with reference to the figures and description, but it will be appreciated that scope of protection extends beyond the example shown and defined in the claim scope.

## Claims

1. A cell assembly (100) comprising:
a cell (101);
a cell enclosure (102) configured to substantially surround the cell; and
an optical sensor (300) deployed within the cell in a location where a chemical environment is active to monitor at least one of temperature, strain and an acoustic signature, the optical sensor configured in use to receive a pulse of light and output a signal which is detectable with an optical monitor (402).

2. The cell assembly (100) according to claim 1, wherein the optical monitor (402) comprising a Bragg grating.

3. The cell assembly (100) according to claim 1 or claim 2, wherein the output signal received from the optical monitor (402) undergoes a frequency response analysis to determine any anomalous temperature data, strain data or acoustic signature.

4. The cell assembly (100) according to any one of the preceding claims, wherein the output signal provides information relating to at least one of:
charging and discharging of the cell (101) which enable identification of the state of charge or health of the cell;
identifying anode cracking based on a specific acoustic response;
detecting electrolyte evaporation prior to a thermal runaway event; and identifying a specific acoustic signature for a rupture of the cell (101).

5. The cell assembly (100) according to any one of the preceding claims, wherein the output signal gives rise to remedial action depending on the nature of an acoustic signature.

6. The cell assembly (100) according to any one of the preceding claims, wherein the output signal is compared to a predetermined safety value and wherein an alarm is produced if the output signifies a risk situation.

7. The cell assembly (100) according to any one of the preceding claims, wherein the optical sensor (300) is located in a cavity in the cell (101).

8. The cell assembly (100) according to claim 7, wherein the optical sensor (300) that is embedded in the cell follows a folded path through the cavity in the cell that takes the form of a zigzag, z-shaped or snaked path to enhance retention.

9. The cell assembly (100) according to any one of the preceding claims, further comprising a printed sensor (104) for monitoring at least one of strain and temperature.

10. A cell assembly safety system (400) for use with the cell assembly of any one of the preceding claims, comprising:
an analysis module (404, 406, 408) for each of one or more sensors configured to receive data from a respective one of one or more sensors;
a control module (410) for controlling the cell assembly safety system and generating alerts where the safety level indicates a risk.

11. A cell assembly safety system according to claim 10, wherein the one or more analysis modules receive input from one or more of:
a printed sensor (104);
an acoustic sensor (106); and
an optical sensor (300).

12. A method of monitoring a cell assembly according to any one of claim 1 to 9, to determine a safety value of the cell (101), the method comprising sensing, via an optical sensor (300), one or more acoustic signatures representing respective electrochemical reactions in the cell (101) to determine a state of health or state of charge of the cell or generate a safety value.

13. The method according to claim 12, further comprising:
sensing a combination of the following signatures:
a continuous acoustic signature;
a pulse type acoustic signature;
an acoustic signature related to acoustic emissions from electrolyte evaporation; and
a gas formation acoustic signature of cell venting.

14. The method according to claim 13, wherein the combination includes the acoustic signature and the gas formation acoustic signature.

15. The method according to claim 13, wherein the combination includes:
the continuous acoustic signature;
the pulse type acoustic signature;
the acoustic signature; and
the gas formation acoustic signature.
